Europäisches Patentamt

European Patent Office

Office européen des brevets

(19)

(11) Numéro de publication : **0 524 294 B1**

(12)

# FASCICULE DE BREVET EUROPEEN

(45) Date de publication du fascicule du brevet :
22.11.95 Bulletin 95/47

(51) Int. Cl.⁶ : **H03G 1/04, H03G 7/00**

(21) Numéro de dépôt : **92905353.6**

(22) Date de dépôt : **31.01.92**

(86) Numéro de dépôt international :
**PCT/FR92/00088**

(87) Numéro de publication internationale :
**WO 92/14302 20.08.92 Gazette 92/22**

(54) **CIRCUIT D'AMPLIFICATION A COMMANDE DE GAIN EXPONENTIELLE.**

(30) Priorité : **08.02.91 FR 9101484**

(43) Date de publication de la demande :
**27.01.93 Bulletin 93/04**

(45) Mention de la délivrance du brevet :
**22.11.95 Bulletin 95/47**

(84) Etats contractants désignés :
**DE FR GB NL**

(56) Documents cités :
**EP-A- 0 003 509**
**EP-A- 0 220 043**
**EP-A- 0 287 063**
**EP-A- 0 391 786**
**DE-A- 2 545 535**
**DE-A- 3 012 965**
**US-A- 4 816 772**

(73) Titulaire : **THOMSON-CSF
SEMICONDUCTEURS SPECIFIQUES
173, Boulevard Haussmann
F-75008 Paris (FR)**

(72) Inventeur : **DEBROUX, Jean-François
Thomson-CSF SCPI
F-92045 Paris-La Défense Cédex 67 (FR)**

(74) Mandataire : **Guérin, Michel et al
THOMSON-CSF
SCPI
B.P. 329
50, rue Jean-Pierre Timbaud
F-92402 Courbevoie Cédex (FR)**

## Description

L'invention concerne un circuit d'amplification électrique de signaux, et plus particulièrement un circuit d'amplification dont le gain peut être commandé à volonté par une grandeur électrique (courant ou tension).

Un des buts de l'invention est de réaliser un amplificateur dont la commande de gain soit exponentielle, c'est-à-dire que si la grandeur électrique de commande est un signal Vc (tension) ou Ic (courant), le gain G sera de la forme $G = A.\exp(Vc)$ ou $A.\exp(Ic)$, A étant une constante.

Un besoin se fait sentir pour un tel amplificateur lorsqu'on a besoin de faire varier le gain avec une très grande dynamique (par exemple variation entre 1 et $10^6$).

La solution normale pour réaliser un tel amplificateur, est d'insérer un élément à variation exponentielle en amont d'une entrée de commande de gain d'un amplificateur à commande de gain linéaire.

Mais il n'est pas facile de le faire, et il n'est pas sûr que l'amplificateur à commande de gain linéaire ait un gain véritablement linéaire dans toute la dynamique des tensions qui vont servir à le commander; cette dynamique est par hypothèse importante du fait de la nature exponentielle de la commande.

D'autre part on a besoin d'être sûr de la loi de variation entre la commande de gain et le gain obtenu.

En effet, dans certaines applications il n'est pas suffisant de savoir que le gain peut varier dans une grande dynamique à l'aide d'un signal de commande de faible dynamique : il peut aussi être nécessaire de connaître précisément le gain obtenu .

L'invention propose une solution résolvant ces problèmes de commande de gain exponentielle, et permettant de résoudre aussi, si on le désire, les problèmes de dépendance du gain avec la température.

Selon l'invention, on utilise d'une manière originale une partie d'une structure connue du brevet FR 2 645 370 ou du brevet EP-A-0 391 786, en remarquant que cette structure permet de réaliser une commande de gain exponentielle à partir d'une fonction logarithmique insérée à un endroit approprié du circuit.

Or la fonction logarithmique est une fonction qu'on sait réaliser à peu de frais dans les circuits intégrés, à l'aide de jonctions bipolaires; la loi de variation logarithmique courant/tension est bien connue, et, de plus, la loi de dépendance avec la température est aussi bien connue.

L'invention propose donc un circuit d'amplification à gain commandé par un signal électrique de consigne (courant ou tension), comprenant deux amplificateurs identiques à gain commandé, recevant tous deux un même signal de commande de gain, le premier amplificateur recevant un signal à amplifier et fournissant un signal de sortie amplifié, le deuxième recevant un signal de référence fixe et fournissant à sa sortie un signal proportionnel à ce signal de référence et au gain des amplificateurs, le circuit comprenant en outre une entrée de signal de consigne de gain et une boucle d'asservissement recevant la sortie du deuxième amplificateur et établissant ledit signal de commande de gain en fonction du signal de consigne, cette boucle comprenant au moins un amplificateur différentiel à grand gain dont l'entrée différentielle tend à être maintenue à zéro par la boucle d'asservissement, caractérisé en ce qu'un élément de circuit à fonction de transfert logarithmique est inséré dans la boucle d'asservissement entre la sortie du deuxième amplificateur et l'entrée de l'amplificateur différentiel à grand gain.

Cet élément à fonction de transfert logarithmique établit essentiellement une tension ou un courant qui est soit proportionnel au logarithme du signal appliqué à son entrée (et ce signal est une tension Vref ou un courant Iref de référence fixe multiplié par le gain G des amplificateurs), soit plus généralement une fonction linéaire du logarithme de ce signal.

Dans un exemple simple, l'élément à fonction de transfert logarithmique établit un signal proportionnel au logarithme du signal de sortie G.Vref ou G.Iref du deuxième amplificateur; ce signal de sortie (de la forme p.Log(G.Vref) ou p.log(G) + constante) est appliqué à une entrée de l'amplificateur différentiel à grand gain, et le signal de consigne Vc est appliqué à une autre entrée de cet amplificateur différentiel.

Dans un autre exemple, la différence entre le signal de consigne Vc et le logarithme du signal de sortie du deuxième amplificateur est effectuée dans l'élément à fonction de transfert logarithmique lui-même. Cette fonction de transfert est alors une fonction linéaire du logarithme du signal de sortie du second amplificateur. Plus précisément cette fonction linéaire pourra être une combinaison linéaire de ce logarithme et du signal de consigne; elle sera généralement de la forme Vc - p.Log(G) + constante, où p est une constante. Cette fonction sera appliquée de préférence sous forme différentielle entre les entrées de l'amplificateur différentiel à grand gain.

Dans les deux cas, l'asservissement maintient en permanence sensiblement à zéro la tension différentielle d'entrée de l'amplificateur à grand gain, réalisant une égalité entre le signal de consigne Vc et une terme de la forme p.Log(G) ou p.Log(G) + constante. D'où il résulte que le gain est une fonction exponentielle du signal de consigne.

La loi logarithmique sera obtenue de préférence par une jonction PN dont la tension aux bornes est proportionnelle au logarithme du courant qui la traverse.

De préférence, le second amplificateur fournit un courant de la forme $I2 = G.Iref$ ou $I2 = G.Vref$ selon que le signal de référence est une tension ou un courant, et c'est ce courant I2 qui sera appliqué à la jonction PN. La tension aux bornes de la jonction sera une fonction logarithmique du courant appliqué.

La précision de la fonction exponentielle obtenue est liée à la qualité (très bonne et très reproductible) de la fonction de transfert logarithmique, et à la précision d'appariement des amplificateurs (très bonne si les amplificateurs sont construits de manière identique sur un même substrat de circuit intégré).

En pratique, la fonction logarithmique établie par les jonctions PN est également proportionnelle à la température absolue T. La température interviendra donc dans la fonction exponentielle liant le gain désiré G au signal de consigne Vc.

Si on s'arrange cependant pour que le signal de consigne appliqué à l'entrée de l'amplificateur différentiel soit lui aussi proportionnel à la température absolue, on aura une commande de gain exponentielle indépendante de la température, le paramètre T n'intervenant plus qu'au second degré dans la commande de gain.

Les signaux électriques mentionnés, que ce soit le signal de référence, le signal de consigne, les signaux à l'entrée de l'amplificateur différentiel, ou d'autres, peuvent être indifféremment des tensions ou des courants, et ce ne sont pas nécessairement tous des tensions ou tous des courants; c'est le détail pratique des schémas de réalisation qui dicte si on doit préférer des tensions ou des courants, étant entendu qu'on sait facilement passer de l'un à l'autre dans les techniques de circuit intégré.

Dans la réalisation pratique préférée de l'invention, la fonction de transfert logarithmique comprend simplement deux transistors alimentés l'un par le courant I2 = G.Iref et l'autre par un courant de référence fixe proportionnel à Iref; le signal de consigne est une tension différentielle appliquée entre les bases des deux transistors, et la sortie de la fonction de transfert logarithmique est la tension différentielle entre les émetteurs.

La fonction de transfert est alors de la forme :
Vc - (kT/q)LogG, ou Vc - (kT/q)Log(G) + constante
k et q sont les constantes physiques classiques régissant l'équation tension/courant logarithmique des jonctions base-émetteur de transistors.

k : constante de Bolzmann = $1.38 \cdot 10^{-23}$ unités S.I.

q : charge de l'électron = $1.6 \cdot 10^{-19}$ unités S.I.

De manière générale, les amplificateurs identiques n'ont pas nécessairement un gain supérieur à 1; dans la pratique, il s'agira d'ailleurs plutôt d'atténuateurs à gain variable entre 0 et 1. Le terme amplifateur appliqué aux amplificateurs est donc pris dans un sens générique.

D'autres caractéristiques et avantages de l'invention apparaîtront à la lecture de la description détaillée qui suit et qui est faite en référence aux dessins annexés dans lesquels :

- la figure 1 représente un schéma-bloc du circuit d'amplification selon l'invention;
- la figure 2 représente le principe de base d'une fonction de transfert logarithmique en circuit intégré.
- la figure 3 représente une extension possible de l'invention;
- la figure 4 représente l'application à une structure entièrement différentielle;
- la figure 5 représente un schéma-bloc du circuit d'amplification de l'invention, dans une réalisation préférée;
- la figure 6 représente la constitution du premier amplificateur dans une réalisation pratique, les premiers et second amplificateurs étant ici des amplificateurs de courant;
- la figure 7 représente le deuxième amplificateur, identique au premier mais recevant un signal d'entrée différent;
- la figure 8 représente la réalisation détaillée préférée de l'élément à fonction de transfert logarithmique;
- la figure 9 représente un exemple de réalisation d'une tension de commande proportionnelle à la température;
- la figure 10 représente un schéma détaillé d'un exemple de réalisation de l'invention;
- la figure 11 représente une constitution possible de l'étage de sortie du circuit selon l'invention.

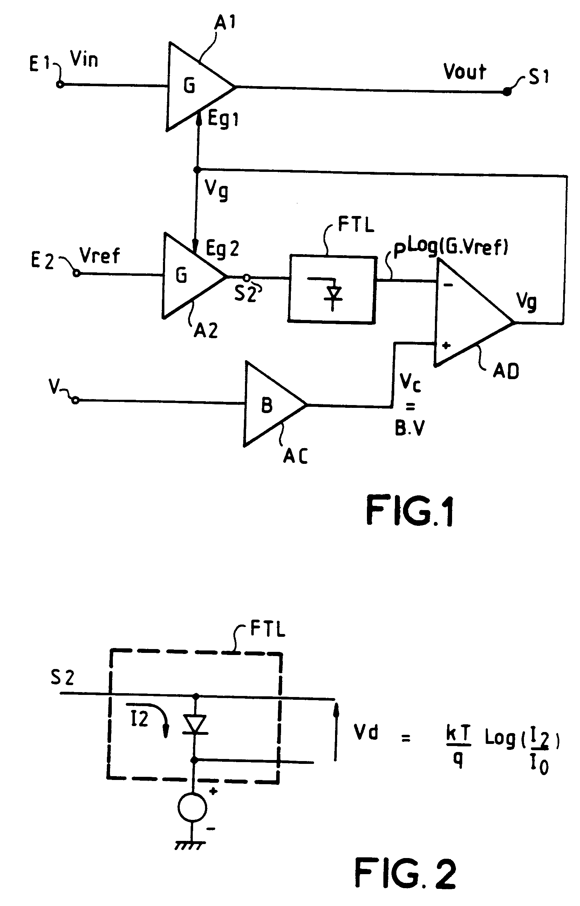

Le schéma de principe de l'invention est visible à la figure 1.

Le circuit d'amplification comporte une entrée E1 pour un signal d'entrée Vin, une sortie S1 pour un signal de sortie Vout. Un premier amplificateur A1 est connecté entre l'entrée E1 et la sortie S1. C'est l'amplificateur utile du circuit. Les autres éléments de circuit sont destinés à la commande de gain. L'amplificateur A1 comporte un entrée de commande de gain (Eg1) et son gain G est une fonction (pas forcément bien connue, et pas forcément une fonction simple, mais tout au moins une fonction monotone) du signal de commande de gain Vg appliqué à l'entrée Eg1. Le signal de sortie Vout est le produit de Vin par le gain G. Par "signal" on entend une grandeur électrique qui peut être indifféremment une tension ou un courant; le signal de sortie pourrait par exemple être un courant alors que le signal d'entrée est une tension, auquel cas le gain G est une transconductance. Dans la suite des explications relatives à la figure 1, on considérera que Vin et Vout et les autres niveaux de signaux mentionnés sont des tensions.

Un deuxième amplificateur A2, aussi identique que possible au premier, possède une entrée E2 recevant un signal de référence fixe continu, représenté ici par une tension de référence Vref.

La sortie S2 du deuxième amplificateur est appliquée à l'entrée d'un élément de circuit FTL à fonction de transfert logarithmique. Le signal électrique appliqué à cet élément est G.Vref. La fonction de transfert de l'élément FTL est de la forme p.Log(G.Vref); le signal en sortie de l'élément FTL est donc égal, à un coefficient multiplicateur p près, au logarithme du signal d'entrée.

La sortie de l'élément à fonction de transfert logarithmique est appliquée à une première entrée d'un amplificateur différentiel à grand gain AD qui reçoit sur une deuxième entrée un signal de consigne de gain Vc et qui fournit sur sa sortie la tension Vg appliquée aux entrées de commande de gain des amplificateurs A1 et A2.

La boucle d'asservissement de gain, comprenant la sortie de l'amplificateur A2, l'élément FTL, l'amplificateur différentiel AD, et l'entreé de commande de gain de l'amplificateur A2 tend à ramener en permanence vers zéro la tension différentielle à l'entrée de AD, pour autant que le gain de AD soit suffisamment élevé. Il en résulte un certain gain G de l'amplificateur A2. Le gain de l'amplificateur A1 est une simple recopie du gain G puisque les amplificateurs sont identiques et reçoivent la même tension de commande de gain Vg.

Dans l'exemple représenté, la tension de consigne Vc est issue d'un amplificateur supplémentaire AC qui reçoit à son entrée un signal V. L'amplicateur AC a un gain B, de sorte que le signal de consigne Vc appliqué à l'entrée de l'amplificateur différentiel AD est égal à B.V. Là encore, la fonction de transfert de cet amplificateur auxiliaire peut être de type amplificateur de tension, amplificateur de courant, transconductance, résistance, etc. Le gain B peut avantageusement être proportionnel à la température absolue T, comme on le verra plus loin.

La boucle d'asservissement établit un équilibre entre le signal B.V et le signal p.Log(G.Vref).

Il en résulte que le gain G de l'amplificateur A2 prend une valeur telle que :

$$B.V = p \, Log(G.Vref)$$

soit

$$G = (1/Vref)exp(B.V/p)$$

B et p sont des constantes liées aux fonctions de transfert de l'élément FTL et de l'amplificateur supplémentaire AC. D'autre part Vref est une tension fixe.

On obtient donc une variation de gain de type exponentielle en fonction d'une tension de commande V.

Le gain de l'amplificateur utile A1 est aussi égal à G et suit donc la loi de commande désirée.

A chaque instant on connaît exactement la valeur du gain G par la simple connaissance de la valeur du signal de commande V, puisque la loi exponentielle qui relie V à G peut être très bien connue si on connaît Vref, p et B.

L'élément FTL à fonction de transfert logarithmique peut comprendre essentiellement une jonction PN; le signal d'entrée est le courant appliqué à la fonction (l'amplificateur A2 ayant alors par exemple une sortie en courant fournissant un courant I2 = G-.Vref) et le signal de sortie est la tension Vd aux bornes de la jonction.

La figure 2 représente un schéma de principe simplifié de cette possibilité.

La fonction de transfert est alors $Vd = kT/qLog(I2/I0)$, où k, q, sont des constantes physiques, I0 une constante analogue à un courant (courant de saturation de la jonction), liée à la géométrie et aux dopages de la jonction, et T est la température absolue .

Si on suppose que Vref est indépendant de la température, ainsi que le signal V de réglage de gain, on voit que l'on peut rendre le gain G indépendant de la température à condition de prévoir qué l'amplicateur AC a un gain B proportionnel à la température absolue (B = B0.T), ce que l'on sait faire.

On remarquera que si l'on veut augmenter la dynamique de gain du circuit d'amplification selon l'invention sans changer le signal de commande, on peut mettre en cascade plusieurs amplificateurs identiques A1, A'1, A''1, tous commandés par le même signal de commande de gain Vg issu de AD.

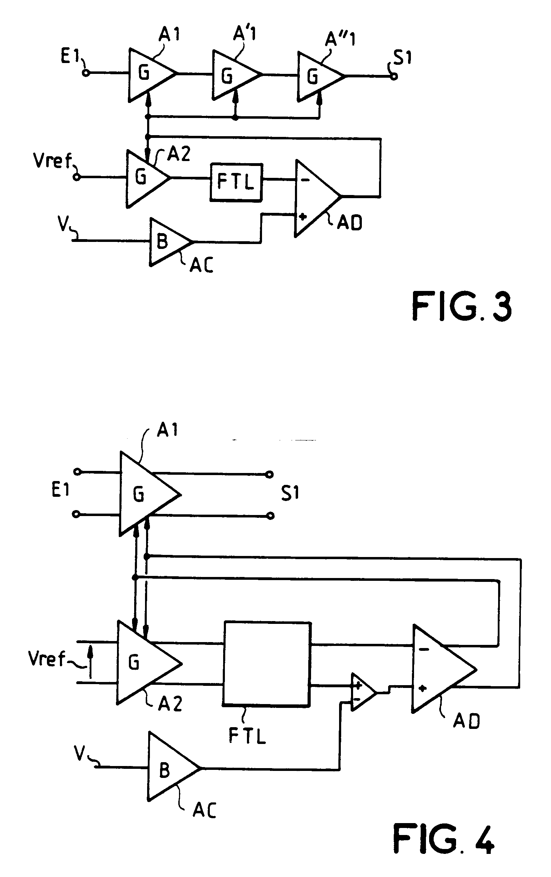

La figure 3 représente un schéma correspondant.

Bien entendu, les tensions et courants considérés peuvent être des courants et tensions différentielles, les amplificateurs A1, A2 et l'élément FTL étant des circuits à entrées et sorties différentielles, l'amplificateur AD ayant en outre une sortie différentielle. Dans ce cas, le terme I0 dépendant de la technologie n'intervient plus.

La figure 4 représente un schéma correspondant.

D'une manière générale, on remarquera que l'invention permet de limiter à une valeur faible les tensions présentes sur les entrées de l'amplificateur différentiel : ces tensions sont d'une part la tension de consigne et d'autre part la tension de sortie d'un élément logarithmique. Ce ne serait pas le cas si un élément à fonction exponentielle était placé en série entre la tension V et l'amplificateur différentiel. Or il est important que l'amplificateur différentiel reçoive des tensions dans une dynamique limitée si on veut qu'il joue correctement son rôle dans l'asservissement.

On va maintenant décrire, en référence aux figures suivantes, une réalisation détaillée de l'invention, appliquée à une technologie de circuits intégrés bipolaires.

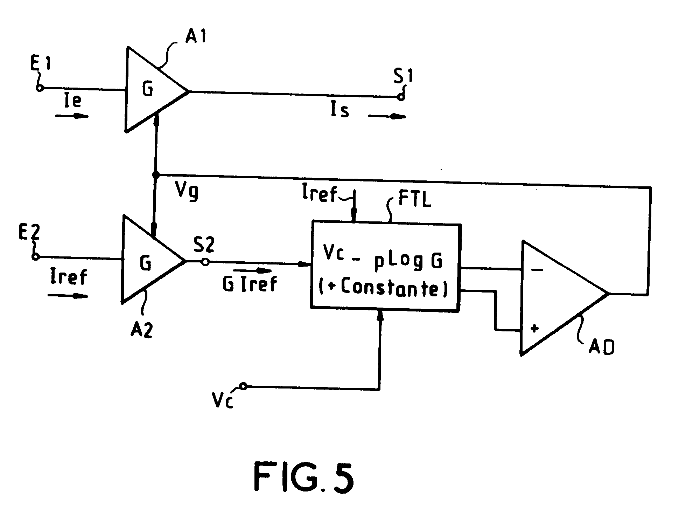

Tout d'abord, la figure 5 représente un schéma-bloc de la réalisation détaillée qu'on va décrire ensuite. Ce schéma bloc diffère formellement de celui de la figure 1 mais accomplit exactement la même fonction globale.

Dans ce schéma, l'élément à fonction logarithmique FTL établit directement la différence entre le signal de consigne Vc et le logarithme du signal de sortie du deuxième amplificateur.

L'élément FTL reçoit donc à la fois le signal de sortie du second amplificateur et le signal de consigne Vc, et il établit une fonction de sortie de la forme : Vc - p.LogG + constante. Cette fonction est fournie sous forme d'une tension différentielle qui est alors appliquée à l'entrée de l'amplificateur différentiel à grand gain AD. On comprend par conséquent facilement que la différence principale par rapport à la figure 1 est purement formelle puisqu'elle consiste à effectuer une soustraction dans l'élément FTL plutôt que dans l'amplificateur différentiel AD qui le suit immédiatement. Mais comme la réalité du schéma des figures suivantes correspond mieux à la représentation de la figure 5, on a préféré partir de cette dernière. Le reste du schéma est le même qu'à la figure 1.

Dans cet exemple, il faut signaler par ailleurs qu'on utilise comme amplificateurs A1 et A2 des amplificateurs de courant, de gain G :
- l'amplificateur A1 reçoit un courant d'entrée Ie et fournit un courant de sortie Is = G.Ie
- l'amplificateur A2 reçoit un courant d'entrée de référence Iref et fournit un courant de sortie G.Iref.

Il importe peu de savoir si la commande de gain (Vg) est en tension ou en courant; il suffit de savoir que la sortie de l'amplificateur différentiel AD est reliée à une entrée de commande de gain des amplificateurs A1 et A2 et que le gain varie de manière monotone en fonction des variations de courant ou de tension à la sortie de l'amplificateur AD.

Comme à la figure 1, il est clair que lorsque l'asservissement fonctionne, c'est-à-dire lorsque le gain G atteint une valeur telle que la tension différentielle d'entrée de l'amplificateur AD soit pratiquement nulle, il y a une relation exponentielle entre la tension de consigne Vc et le gain G, par l'intermédiaire de la formule :

$$Vc - p.Log(G) + constante = 0$$

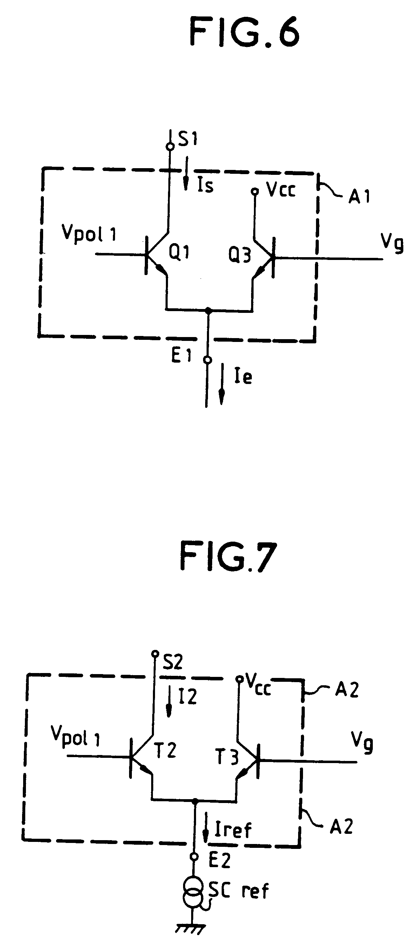

La figure 6 représente la structure d'une cellule à gain variable qui représente le coeur des amplificateurs identiques A1 et A2.

Ces cellules sont des amplificateurs courant-courant de gain G. L'amplificateur A1 peut être entouré d'éléments en amont et en aval, pour tenir compte de conversions courant-tension ou tension-courant souhaitées, ou de préamplification ou post-amplification souhaitées, avec des coefficients de conversion et d'amplification fixes connus, mais ce sont les cellules de gain G qui constituent ce qu'on a appelé amplificateurs de construction identique en référence à la figure 1.

A ce sujet, il faut préciser que par amplificateurs de construction identique, on entend des amplificateurs qui subissent globalement la même variation de gain sous la commande du même signal de modification de gain. Il faut bien comprendre par conséquent qu'il peut y avoir quelques différences de construction entre les amplificateurs A1 et A2, pour des raisons pratiques, si on parvient au même résultat, c'est-à-dire si les gains des amplificateurs A1 et A2 varient de la même manière.

La cellule de la figure 6 représente plus précisément la cellule d'amplification A1, c'est-à-dire celle qui reçoit un signal de commande de gain Vg et un courant d'entrée Ie à amplifier, pour fournir un courant de sortie Is = G.Ie.

La cellule comporte deux transistors Q1 et Q3 dont les émetteurs sont reliés à une entrée E1 de la cellule. C'est cette entrée qui reçoit le courant Ie (représenté ici par un courant sortant de la cellule). Le courant Ie est la somme des courants d'émetteur des transistors Q1 et Q3. Le collecteur de Q1, relié à la sortie S1 de la cellule, fournit le courant Is de sortie de la cellule (représenté comme un courant rentrant dans la cellule). La base de Q1 est polarisée par une tension fixe Vpol1. Le collecteur de Q3 est alimenté par une tension d'alimentation Vcc.

Le rapport entre le courant Is et le courant Ie est modulé par une tension Vg appliquée à la base du transistor Q3 : selon la valeur de Vg, le transistor Q3 contribue plus ou moins au courant Ie, et par conséquent le courant Is diminue ou augmente plus ou moins en conséquence. Le gain en courant G de la cellule, qui est le rapport entre Is et Ie, est donc directement fonction de Vg. On notera qu'il est inférieur à 1.

A la figure 7, on a représenté la cellule de base de l'amplificateur A2, identique à la cellule A1 de la figure 6 mais recevant comme courant d'entrée un courant de référence Iref au lieu du courant Ie. L'entrée de la cellule est désignée par E2 et elle est reliée à une source de courant SCref. La sortie est désignée par S2 et fournit un courant I2 = G.Iref.

La cellule A2 comporte deux transistors T2 et T3 jouant des rôles identiques à ceux des transistors Q1 et Q3 respectivement, et connectés par conséquent comme ces derniers.

La base de T3 reçoit la même tension de commande Vg que la base de Q3. La base de T2 reçoit la même tension de polarisation Vpol1 que la base de Q1.

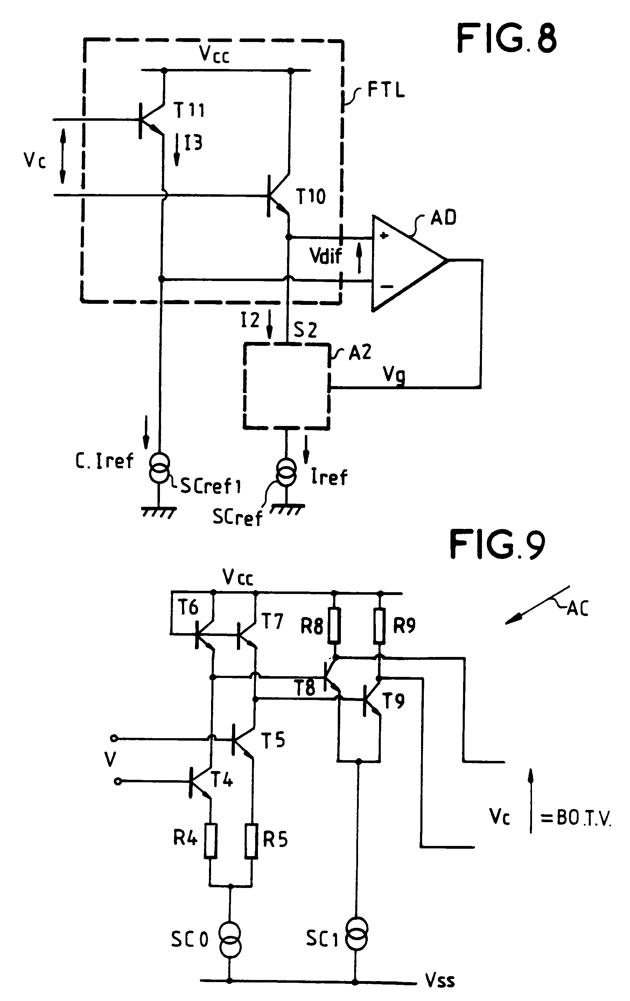

La figure 8 représente la réalisation préférée pour l'élément à fonction de transfert logarithmique FTL.

Conformément au schéma-bloc de la figure 5, cet élément FTL reçoit d'une part le courant I2 = G.Iref issu de l'amplificateur A2, et d'autre part la tension de consigne Vc qui est ici une tension différentielle.

L'élément FTL comporte deux transistors T10 et T11 dont les collecteurs sont reliés à une tension d'alimentation (Vcc).

L'émetteur de T10 est relié à la sortie S2 de la cellule d'amplification A2, de sorte que le courant d'émetteur de T10 est obligatoirement le courant I2 = G.Iref mentionné précédemment.

Par ailleurs, l'émetteur de T11 est relié à une source de courant de référence fixe SCref1, proportionnelle à Iref, avec un coefficient de proportionalité qu'on désignera par C. Le transistor T11 est donc parcouru par un courant d'émetteur I3 = C.Iref.

On rappelle qu'en technologie de circuits intégrés on sait très bien établir des courants de référence proportionnels les uns aux autres avec des coefficients de proportionalité bien connus.

La source de courant SCref1 sera tout simplement établie par miroir de courant à partir de la source SCref qui fournit le courant d'entrée de la cellule A2.

En résumé, l'élément FTL comprend les transistors T10 et T11 et, pour alimenter T11, une source de courant de valeur proportionnelle au courant d'entrée de la cellule A2.

La tension de consigne Vc est appliquée en différentiel directement entre les bases de T10 et T11.

La sortie de l'élément FTL est la tension différentielle Vdif présente entre les émetteurs de T10 et T11; cette tension Vdif est appliquée entre les entrées de l'amplificateur différentiel à grand gain AD.

La tension Vdif est égale à :

$$Vdif = Vc - (Vbe10 - Vbe11)$$

où Vbe11 et Vbe10 sont les tensions base-émetteur des transistors T11 et T10. Cette tension tend vers zéro par suite de l'asservissement.

Or, compte-tenu des courants I2 et I3 qui traversent les transistors, la différence Vbe10 - Vbe11 peut s'écrire sous la forme p.Log(I2/I3), c'est-à-dire sous la forme p.Log(G.Iref/C.Iref), ou encore p.Log(G/C) qui peut aussi s'écrire p.Log(G) + constante.

Il en résulte que l'élément FTL de la figure 8 remplit bien la fonction de transfert logarithmique mentionnée à propos de la figure 5 : la tension de commande Vc agit, par l'intermédiaire de l'amplificateur AD, pour modifier le courant I2 jusqu'à respecter l'équation Vc = pLog(G) + constante.

On notera que p est un coefficient du type kT/q, donc proportionnel à la température absolue.

Avec cette réalisation pratique, on voit que le gain G des amplificateurs A1 et A2 prend la valeur

$$G = C.exp(Vc/p)$$

La température intervient dans l'exponentielle puisque p est proportionnel à T.

Si on veut rendre le gain indépendant de la température, il suffit de prévoir, comme à la figure 1, un amplificateur AC de gain B proportionnel à la température (B = B0.T) en amont de l'entrée de signal de consigne de gain Vc, pour fournir la tension de consigne Vc à partie d'une tension de commande V.

Dans ce cas, on a Vc = B.V = B0.T.V

Le gain G devient

$$G = C.exp(B0.T.V/p)$$

qui est une fonction exponentielle de la tension de commande V, indépendante de la température (au moins au premier degré).

On sait faire des amplificateurs AC dont le gain en tension est proportionnel à la température absolue et qui fournissent un signal de sortie différentiel.

La figure 9 est un exemple simplifié d'un tel amplificateur AC.

L'amplificateur AC comporte deux étages. Le premier comprend une paire de branches différentielles à deux transistors d'entrée T4 et T5, deux résistances d'émetteur R4 et R5 et deux transistors de charge montés en diode T6 et T7. La paire différentielle est alimentée par un courant constant produit par une source SC0 reliée aux émetteurs des transistors d'entrée. L'entrée de l'amplificateur est une tension de commande V appliquée entre les bases des transistors T4 et T5. La sortie du premier étage se fait en tension différentielle sur les émetteurs des transistors de charge T6 et T7. Les bases et collecteurs de ces derniers sont reliés à une tension d'alimentation fixe (Vcc par exemple).

Le deuxième étage comporte une autre paire différentielle avec respectivement un transistor et une résistance de collecteur dans chaque branche (T8, R8; T9, R9). Les émetteurs sont reliés entre eux et alimentés par une source de courant constant SC1. Les résistances sont reliées entre le collecteur et un potentiel d'alimentation fixe (Vcc par exemple).

La sortie de l'amplificateur AC se fait en tension différentielle entre les collecteurs des transistors T8 et T9. La tension Vc qui apparaît là est proportionnelle à la tension de réglage V.

Les sources de courant SC0 et SC1 ne sont pas de même nature. La source SC0 est une source de courant compensée en température. La source SC1 est proportionnelle à la température absolue.

La différence de potentiel V engendre un déséquilibre de courants dans T4 et T5, donc une différence de potentiel entre les émetteurs de T6 et T7; cette différence, reportée sur les bases de T8 et T9, engendre à nouveau un déséquilibre de courants dans T8 et T9, et ce déséquilibre engendre, à travers les résistances R8 et R9, une différence de potentiel de sortie Vc.

Du fait que la source de courant SC0 est compensée en température mais que SC1 est proportionnel à la température, la tension de sortie Vc s'avère être, en bonne approximation, proportionnelle à la température absolue et proportionnelle à la tension V.

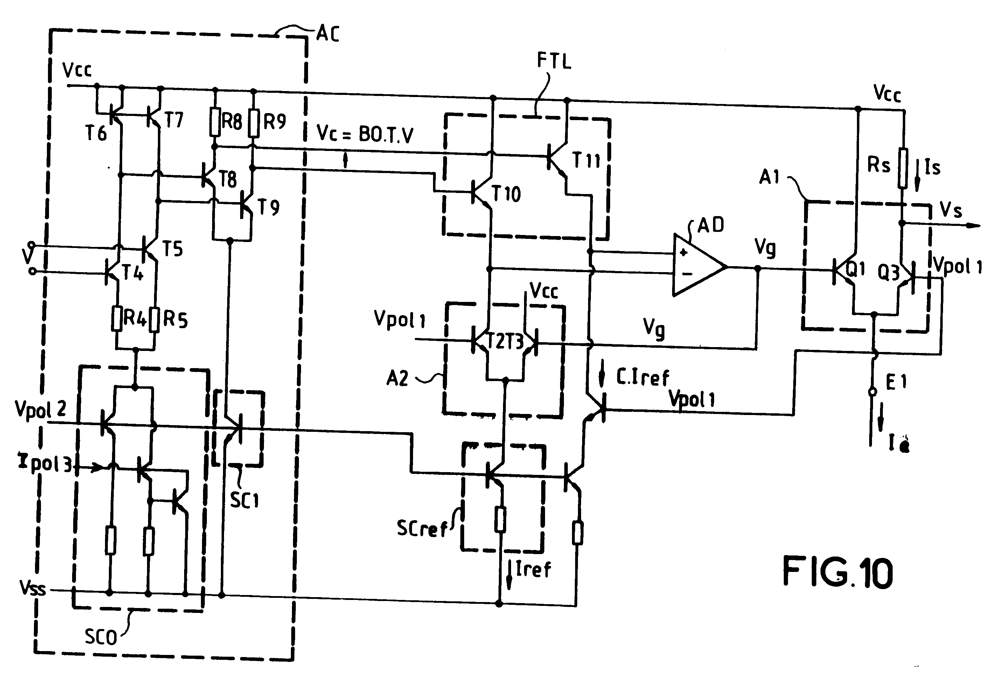

A la figure 10, on a représenté un schéma d'ensemble détaillé de la réalisation décrite. Ce schéma reprend les éléments des figures 6 à 9, en les complétant éventuellement; les références sont les mêmes qu'aux figures 6 à 9. Des tensions de polarisation Vpol2 et Vpol3 ont été représentées en plus de la tension Vpol1; elles servent à alimenter les bases de transistors qui constituent des sources de courant, notamment les sources SCref,SCref1, SC0 et SC1.

Sur la figure 10 on a supposé que l'entrée du circuit d'amplification est une entrée en courant (Ie) et que la sortie est une sortie en tension Vs. Pour cela, par rapport au schéma de cellule A1 de la figure 6, on a rajouté sur la figure 10 une résistance Rs entre Vcc et le collecteur de Q3, et la sortie en tension est prise au point de jonction de Q3 et Rs.

Par ailleurs, si on désirait que l'entrée du circuit d'amplification de la figure 10 soit une entrée en tension, on rajouterait en amont de l'entrée E1 de la cellule A1 un étage de conversion tension-courant.

Si enfin on désire par exemple un circuit d'amplification ayant une entrée différentielle en tension et une sortie différentielle en tension, on peut prévoir deux cellules telles que A1 fonctionnant en parallèle, commandées toutes deux par l'amplificateur AD, recevant des courants d'entrée de deux branches différentielles d'un étage à entrée en tension différentielle, les cellules fournissant des courants de sortie à deux résistances telles que Rs. La sortie se fait en différentiel entre les deux résistances.

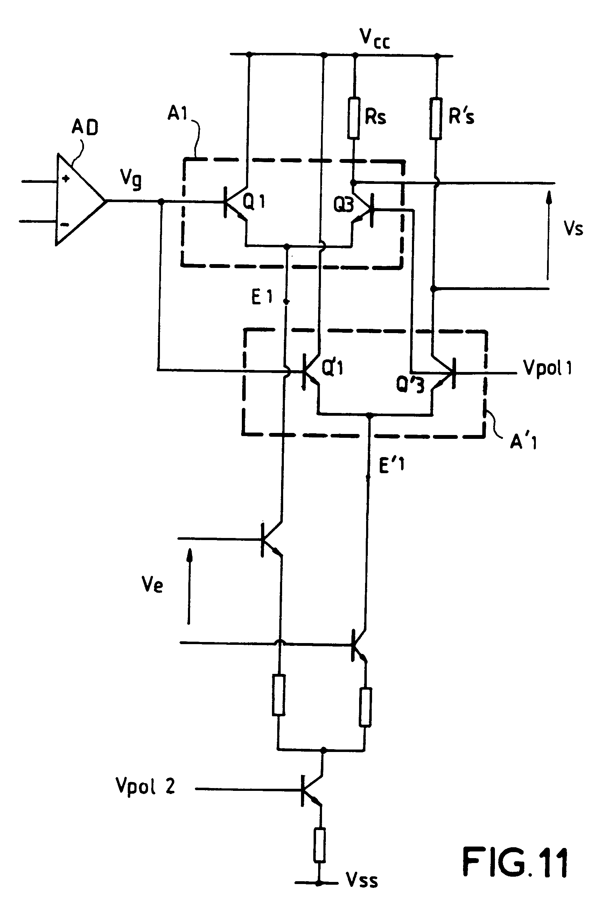

La figure 11 représente cette constitution du circuit d'amplification avec deux cellules symétriques A1 et A'1. Les amplificateurs AC, A2 et l'élément FTL ne sont pas repris; ils peuvent être identiques à ceux de la figure 10.

## Revendications

1. Circuit d'amplification à gain commandé par un signal électrique de consigne de gain, comprenant deux amplificateurs identiques à gain commandé (A1, A2), recevant tous deux un même signal de commande de gain (Vg), le premier amplificateur (A1) recevant un signal à amplifier et fournissant un signal de sortie amplifié, le deuxième amplificateur (A2) recevant un signal de référence fixe à amplifier et fournissant à sa sortie un signal proportionnel à ce signal de référence et au gain (G) des amplificateurs, le circuit comprenant en outre une entrée de signal de consigne de gain (Vc) et une boucle d'asservissement recevant la sortie du deuxième amplificateur (A2) et établissant ledit signal de commande de gain en fonction du signal de consigne, cette boucle comprenant au moins un amplificateur différentiel à grand gain (AD) dont l'entrée différentielle tend à être maintenue à zéro par la boucle d'asservissement, caractérisé en ce qu'un élément de circuit à fonction de transfert logarithmique (FTL) est inséré dans la boucle d'asservissement entre la sortie du deuxième amplificateur (A2) et l'entrée de l'amplificateur différentiel à grand gain (AD).

2. Circuit d'amplification selon la revendication 1, caractérisé en ce que l'élément à fonction de transfert logarithmique (FTL) établit un signal proportionnel au logarithme du signal appliqué à son entrée.

3. Circuit selon la revendication 2, caractérisé en ce que la sortie de l'élément à fonction de transfert logarithmique est appliquée à une entrée de l'amplificateur différentiel à grand gain (AD), et le signal de consigne (Vc) est appliqué à une autre entrée de cet amplificateur différentiel.

4. Circuit selon la revendication 1, caractérisé en ce que la fonction de transfert logarithmique est une combinaison linéaire du logarithme du signal de sortie du deuxième amplificateur et du signal de consigne, cette combinaison étant de la forme Vc - p.Log(G) + constante, où p est une constante, Vc le signal de consigne du gain et G le gain des deux amplificateurs.

5. Circuit selon la revendication 4, caractérisé en ce que la sortie de l'élément à fonction de transfert logarithmique (FTL) est appliquée sous forme différentielle entre les entrées de l'amplificateur différentiel à grand gain (AD).

6. Circuit selon la revendication 1, caractérisé en ce que l'élément à fonction de transfert logarithmique comporte deux transistors (T10, T11) alimentés l'un par le courant issu du deuxième amplificateur, l'autre par un courant proportionnel au signal de référence fixe appliqué à l'entrée du deuxième amplificateur, en ce que le signal de consigne de gain (Vc) est une tension différentielle appliquée entre les bases des deux transistors, et en ce que la sortie de l'élément à fonction de transfert logarithmique est la tension différentielle entre les émetteurs de ces transistors.

7. Circuit selon l'une des revendications 1 à 6, caractérisé en ce que les amplificateurs identiques sont des amplificateurs courant-courant comportant chacun un premier transistor (Q1, T2) dont la base est polarisée à une tension fixe, un deuxième transistor (T3, Q3) dont la base reçoit la sortie de l'amplificateur différentiel (AD), les émetteurs des deux transistors étant réunis et le courant global appliqué à ces émetteurs constituant le courant d'entrée de l'amplificateur, le collecteur du deuxième transistor (T3, Q3) étant relié à une source d'alimentation en tension (Vcc) et le courant sur le collecteur du premier transistor (Q1, T2) constituant le courant de sortie de l'amplificateur.

8. Circuit selon l'une des revendications 1 à 7, caractérisé en ce les amplificateurs identiques fournissent des sorties en courant, et en ce que l'élément à fonction de transfert logarithmique comporte au moins une jonction PN parcourue par un courant issu du deuxième amplificateur.

9. Circuit selon l'une des revendications précédentes, caractérisé en ce qu'un amplificateur à gain proportionnel à la température absolue est placé en amont de l'entrée de signal de consigne de gain.

**Patentansprüche**

1. Verstärkerschaltung mit durch ein elektrisches Verstärkungseinstellsignal gesteuerter Verstärkung, mit zwei identischen Verstärkern (A1, A2) mit gesteuerter Verstärkung, die beide das gleiche Verstärkungssteuersignal (Vg) empfangen, wobei der erste Verstärker (A1) ein zu verstärkendes Signal empfängt und ein verstärktes Ausgangssignal abgibt, und der zweite Verstärker (A2) ein zu verstärkendes festes Referenzsignal empfängt und an seinem Ausgang ein diesem Referenzsignal und der Verstärkung (G) der Verstärker proportionales Signal liefert, wobei die Schaltung ferner einen Eingang für ein Verstärkungseinstellsignal (Vc) und eine Regelschleife enthält, die das Ausgangssignal des zweiten Verstärkers (A2) empfängt und das Verstärkungssteuersignal abhängig vom Einstellsignal festlegt, wobei diese Regelschleife wenigstens einen hochverstärkenden Differenzverstärker (AD) enthält, bei dem die Regelschleife versucht, die Eingangssignaldifferenz auf Null zu halten, dadurch gekennzeichnet, daß in die Regelschleife zwischen dem Ausgang des zweiten Verstärkers (A2) und dem Eingang des hochverstärkenden Differenzverstärkers (AD) ein Schaltungselement (FTL) mit logarithmischer Übertragungsfunktion eingefügt ist.

2. Verstärkerschaltung nach Anspruch 1, dadurch gekennzeichnet, daß das Element (FTL) mit logarithmischer Übertragungsfunktion ein Signal erzeugt, das zum Logarithmus des an seinen Eingang angelegten Signals proportional ist.

3. Schaltung nach Anspruch 2, dadurch gekennzeichnet, daß daß Ausgangssignal des Elements mit logarithmischer Übertragungsfunktion an einen Eingang des hochverstärkenden Differenzverstärkers (AD) angelegt ist, und daß das Einstellsignal (Vc) an den anderen Eingang dieses Differenzverstärkers angelegt ist.

4. Schaltung nach Anspruch 1, dadurch gekennzeichnet, daß die logarithmische Übertragungsfunktion eine lineare Kombination des Logarithmus des Ausgangssignals des zweiten Verstärkers und des Einstellsignals ist, wobei diese Kombination die Form Vc - p·Log(G) + Konstante hat, wobei p eine Konstante ist, Vc das Verstärkungseinstellsignal ist und G die Verstärkung der zwei Verstärker ist.

5. Schaltung nach Anspruch 4, dadurch gekennzeichnet, daß das Ausgangssignal des Elements (FTL) mit logarithmischer Übertragungsfunktion in Differenzform zwischen die Eingänge des hochverstärkenden Differenzverstärkers (AD) angelegt wird.

6. Schaltung nach Anspruch 1, dadurch gekennzeichnet, daß das Element mit logarithmischer Übertragungsfunktion zwei Transistoren (T10, T11) enthält, von denen der eine durch den Strom aus dem zweiten Verstärker und der andere durch einen dem festen Referenzsignal proportionalen Strom, der an den Eingang des zweiten Verstärkers angelegt ist, gespeist wird, daß das Verstärkungseinstellsignal (Vc) eine Differenzspannung ist, die zwischen die Basisanschlüsse der zwei Transistoren angelegt wird, und daß das Ausgangssignal des Elements mit logarithmischer Übertragungsfunktion die Differenzspannung zwischen den Emitteranschlüssen dieser Transistoren ist.

7. Schaltung nach einem der Ansprüche 1 bis 6, dadurch gekennzeichnet, daß die identischen Verstärker Strom-Strom-Verstärker sind, die jeweils einen ersten Transistor (Q1, T2), dessen Basis auf eine feste Spannung vorgespannt ist, und einen zweiten Transistor (T3, Q3) enthalten, dessen Basis das Ausgangssignal des Differenzverstärkers (AD) empfängt, wobei die Emitter der zwei Transistoren verbunden sind und der an diese Emitter angelegte Gesamtstrom den Verstärkereingangsstrom bildet, wobei die Kollektoren der zwei Transistoren (T3, Q3) mit einer Versorgungsspannungsquelle (Vcc) verbunden sind und der Strom am Kollektor des ersten Transistors (Q1, T2) den Verstärkerausgangsstrom bildet.

8. Schaltung nach einem der Ansprüche 1 bis 7, dadurch gekennzeichnet, daß die identischen Verstärker Stromausgangssignale liefern und daß das Element mit logarithmischer Übertragungsfunktion wenigstens einen PN-Übergang enthält, durch den der aus dem zweiten Verstärker kommende Strom fließt.

9. Schaltung nach einem der vorhergehenden Ansprüche, dadurch gekennzeichnet, daß den Eingang für das Verstärkungseingangssignal ein Verstärker vorgeschaltet ist, dessen Verstärkung der absoluten Temperatur proportional ist.

**Claims**

1. Amplifying circuit with gain controlled by an electrical gain set point signal, comprising two identical controlled-gain amplifiers (A1, A2) both receiving the same gain control signal (Vg), the first amplifier (A1) receiving a signal to be amplified and providing an amplified output signal, the second amplifier (A2) receiving a fixed reference signal to be amplified and providing at its output a signal proportional to this reference signal and to the gain (G) of the amplifiers, the circuit further comprising a gain set point signal input (Vc) and a feedback control loop receiving the output from the second amplifier (A2) and establishing the said gain control signal as a function of the set point signal, this loop comprising at least one large-gain differential amplifier (AD) whose differential input tends to be held at zero by the feedback control loop, characterised in that a circuit element with logarithmic transform function (FTL) is inserted into the feedback control loop between the output of the second amplifier (A2) and the input of the large-gain differential amplifier (AD).

2. Amplifying circuit according to Claim 1, characterised in that the element with logarithmic transform function (FTL) establishes a signal proportional to the logarithm of the signal applied to its input.

3. Circuit according to Claim 2, characterised in that the output of the element with logarithmic transform function is applied to an input of the large-gain differential amplifier (AD), and the set point signal (Vc) is applied to another input of this differential amplifier.

4. Circuit according to Claim 1, characterised in that the logarithmic transform function is a linear combination of the logarithm of the output signal from the second amplifier and the set point signal, this combination being of the form Vc - p.Log(G) + constant, where p is a constant, Vc is the gain set point signal and G is the gain of the two amplifiers.

5. Circuit according to Claim 4, characterised in that the output from the element with logarithmic transform function (FTL) is applied in differential form between the inputs of the large-gain differential amplifier (AD).

6. Circuit according to Claim 1, characterised in that the element with logarithmic transform function includes two transistors (T10, T11), one fed by the current from the second amplifier, the other by a current proportional to the fixed reference signal applied to the input of the second amplifier, in that the gain set point signal (Vc) is a differential voltage between the bases of the two transistors, and in that the output from the element with logarithmic transform function is the differential voltage between the emitters of these transistors.

7. Circuit according to one of Claims 1 to 6, characterised in that the identical amplifiers are current-current amplifiers each including a first transistor (Q1, T2) whose base is biased to a fixed voltage, a second transistor (T3, Q3) whose base receives the output from the differential amplifier (AD), the emitters of the two transistors being joined and the overall current applied to these emitters constituting the amplifier's input current, the collector of the second transistor (T3, Q3) being linked to a voltage-supply source (Vcc) and the current on the collector of the first transistor (Q1, T2) constituting the amplifier's output current.

8. Circuit according to one of Claims 1 to 7, characterised in that the identical amplifiers provide current outputs, and in that the element with logarithmic transform function includes at least one PN junction traversed by a current arising from the second amplifier.

9. Circuit according to one of the preceding claims, characterised in that an amplifier with gain proportional to absolute temperature is placed ahead of the gain set point signal input.

## FIG.1

$$Vd = \frac{kT}{q} \log\left(\frac{I_2}{I_0}\right)$$

## FIG. 2

FIG.3

FIG.4

FIG. 5

# FIG.6

# FIG.7

# FIG.8

$V_{cc}$

T11

$V_c$ $\downarrow$ I3

T10

FTL

Vdif $\uparrow$

AD

$+$

$-$

I2 $\downarrow$ S2

A2

Vg

C.Iref $\downarrow$

SCref1

Iref

SCref

# FIG.9

$V_{cc}$

T6

T7

R8

R9

AC

T8

T9

V

T5

T4

R4

R5

SC0

SC1

$V_c \downarrow$ = B.O.T.V.

Vss

14

FIG.10

FIG.11